# EUROPEAN PATENT APPLICATION

(11) **EP 4 057 507 A1**
(43) Date of publication of application: **14.09.2022**
(21) Application number: 20894019.7
(22) Date of filing: 28.11.2020
(51) Int. Cl.: H03H 9/54

(54) **FILTER CIRCUIT, DUPLEXER, AND COMMUNICATION APPARATUS**

(30) Priority: 29.11.2019 CN 201911211785
(71) Applicant: Huawei Technologies Co., Ltd., Shenzhen, Guangdong 518129 (CN)
(72) Inventor: GU, Jian, Shenzhen, Guangdong 518129 (CN); WANG, Weibiao, Wuxi, Jiangsu 214124 (CN); LIU, Zhiyu, Shenzhen, Guangdong 518129 (CN); TANG, Qingwu, Shenzhen, Guangdong 518129 (CN); ZHANG, Lei, Shenzhen, Guangdong 518129 (CN)
(74) Representative: Körber, Martin Hans
(86) International application number: PCT/CN2020/132536
(87) International publication number: WO 2021/104505

(57) **Abstract**

A filter circuit (100) with good passive inter-modulation performance, a duplexer (100a) including the filter circuit (100), and a communication apparatus (1) are disclosed. The filter circuit (100) includes an input port (In) for receiving a radio frequency signal, a series resonator unit (110), a parallel resonator unit (120), and an output port (Out). The series resonator unit (110) is connected between the input port (In) and the output port (Out). The parallel resonator unit (120) cooperates with the series resonator unit (110) to filter the radio frequency signal, and the radio frequency signal is output through the output port (Out). The parallel resonator unit (120) includes at least two parallel resonance tributaries (120a and 120b) that are connected in parallel to each other. The parallel resonance tributaries (120a and 120b) are both connected between a first node (Nout), between the input port (In) and the output port (Out), and a grounding terminal (GND). The parallel resonator tributaries (120a and 120b) each include at least one parallel resonator. A parallel resonator unit is a parallel resonator unit at a level closest to the output port (Out). The parallel resonator includes a first electrode and a second electrode. An electrode, connected to the first node (Nout), in each parallel resonator tributary is the same.

## Description

This application claims priority to Chinese Patent Application 201911211785.6, filed with the China Patent Office on November 29,2019 and entitled "FILTER CIRCUIT, DUPLEXER, AND COMMUNICATION APPARATUS", which is incorporated herein by reference in its entirety.

### TECHNICAL FIELD

Embodiments of this application relate to the field of radio frequency communication technologies, and in particular, to a filter circuit, a duplexer, and a communication apparatus.

### BACKGROUND

With wide application of communication apparatuses in people's lives, quality of a wireless signal, as an important parameter of a communication apparatus, is used to measure overall quality of the communication apparatus. Both transmission and reception of a wireless signal in a communication apparatus require a filter for filtering. Therefore, the filter has a great impact on quality of the wireless signal.

Currently, as a quantity of wireless signal channels in a communication apparatus increases, passive inter-modulation (Passive Inter Modulation, PIM) interference between filters on each wireless signal channel is large. Consequently, large passive inter-modulation interference noise of radio frequency signals transmitted on each channel is caused, and overall quality of the communication apparatus is further affected.

### SUMMARY

To resolve the foregoing problem, an embodiment of this application provides a filter circuit, a duplexer, and a communication apparatus. A circuit structure in a parallel resonator unit at a level closest to an output port of the filter circuit is adjusted to effectively improve an interference suppression capability of the filter circuit, so that passive inter-modulation of the filter circuit is preferable.

According to a first aspect, an embodiment of this application provides a filter circuit. The filter circuit includes: an input port, a series resonator unit, a parallel resonator unit, and an output port. The input port is configured to receive a radio frequency signal. The series resonator unit is connected between the input port and the output port. After the series resonator unit cooperates with the parallel resonator unit to filter the radio frequency signal, the radio frequency signal is output from the output port. The parallel resonator unit includes M parallel resonator tributaries connected in parallel to each other, the M parallel resonator tributaries are connected between a first node, between the input port and the output port, and a grounding terminal, each of the M parallel resonator tributaries includes at least one parallel resonator, the parallel resonator unit is a parallel resonator unit at a level closest to the output port, and M is a natural number greater than or equal to 2.

Each parallel resonator includes a first electrode of a first polarity and a second electrode of a second polarity. An electrode, connected to the first node, in each parallel resonator tributary is a first electrode of the first polarity; or an electrode, connected to the first node, in each parallel resonator tributary is a second electrode of the second polarity. Because the parallel resonator unit at the level closest to the output port includes two parallel resonance tributaries, PIM3 in passive inter-modulation can be improved and interference overally generated by the filter circuit can be effectively suppressed, thereby ensuring quality a wireless radio frequency signal obtained through filtering. Furthermore, polarities of electrodes, connected to the first node, of parallel resonators in the two parallel resonance tributaries are the same, so that configurations of the parallel resonance tributaries are more simple and convenient. In addition, because the interference can be effectively suppressed by disposing only one parallel resonator on the first node, an overall volume of the filter circuit is effectively reduced.

In an embodiment of this application, when each parallel resonator tributary includes two or more resonators, the two or more parallel resonators are connected in series. Because the parallel resonators are connected in series, a connection manner for the parallel resonators is more simple and convenient.

In an embodiment of this application, when each parallel resonator tributary includes two or three resonators, a design of a parallel resonator unit needs to be balanced, so that a quantity of parallel resonators in a parallel resonator unit and an interference suppression capability can reach a best balance point. To be specific, in this case, the filter circuit has better interference suppression performance and the overall volume of the filter circuit is smaller due to a smaller quantity of parallel resonators.

In an embodiment of this application, a quantity of parallel resonators connected in series in each parallel resonator tributary is different, the interference suppression capability of the filter circuit is adjusted by adjusting the quantity of parallel resonators in each parallel resonator tributary, so that the interference suppression capability of the filter circuit can be adjusted flexibly.

In an embodiment of this application, the series resonator unit has a high impedance characteristic at an anti-resonance frequency, the parallel resonator unit has a high impedance characteristic at a resonance frequency, the series resonator unit and the parallel resonator unit form a bandpass filter, and a central frequency of the bandpass filter is the resonance frequency of the series resonator unit or the anti-resonance frequency of the parallel resonator unit. The series resonator unit cooperates with the parallel resonator unit, so that the filter circuit can further effectively suppress the interference while filtering the received radio frequency signal.

In an embodiment of this application, the filter circuit may be a surface acoustic wave filter or a bulk acoustic wave filter to respectively filter, with low interference, signals transmitted in a form of a surface acoustic wave or a form of a bulk acoustic wave.

According to a second aspect, an embodiment of this application provides a duplexer with better passive inter-modulation. The duplexer includes two filter circuits described above. The two filter circuits respectively filter radio frequency signals in a radio frequency signal receiving direction and a radio frequency signal sending direction, so that when filtering can be performed on the radio frequency signals in both the sending direction and the receiving direction, interference can be well suppressed and the passive inter-modulation is better.

According to a third aspect, an embodiment of this application provides a communication apparatus. The communication apparatus includes at least the foregoing filter circuit. The filter circuit can well suppress interference generated when filtering a radio frequency signal in a transmit frequency band or a receive frequency band and can ensure better passive inter-modulation, so that quality of a signal transmitted in the communication apparatus is better. In an embodiment of this application, the communication apparatus further includes an antenna. The antenna is connected to the filter circuit. The antenna is configured to: receive a radio frequency signal to be filtered by the filter circuit, and transmit a radio frequency signal obtained through filtering performed by the filter circuit.

### BRIEF DESCRIPTION OF DRAWINGS

FIG. 1 is a functional module diagram of a radio frequency communication module;
FIG. 2 is a functional module diagram of a duplexer according to an embodiment of this application;
FIG. 3 is a schematic diagram of a structure of a communication apparatus to which the radio frequency communication module shown in FIG. 1 is applied according to an embodiment of this application;
FIG. 4 is a schematic diagram of a structure of a communication apparatus to which the radio frequency communication module shown in FIG. 1 is applied according to an embodiment of this application;
FIG. 5 is a schematic diagram of a circuit structure of a filter shown in FIG. 1 according to an embodiment of this application;
FIG. 6 is a schematic diagram of a radio frequency signal waveform among working characteristics of a sub serial resonator unit;
FIG. 7 is a schematic diagram of a radio frequency signal waveform among working characteristics of a first parallel resonator unit;
FIG. 8 is a schematic diagram of a radio frequency signal waveform among working characteristics of a filter shown in FIG. 4;
FIG. 9 is a schematic diagram of a circuit structure of the filter shown in FIG. 1 according to another embodiment of this application;
FIG. 10 is a schematic diagram of a circuit structure of the filter shown in FIG. 1 according to another embodiment of this application; and
FIG. 11 is a schematic diagram of a circuit structure of the filter shown in FIG. 1 according to another embodiment of this application.

### DESCRIPTION OF EMBODIMENTS

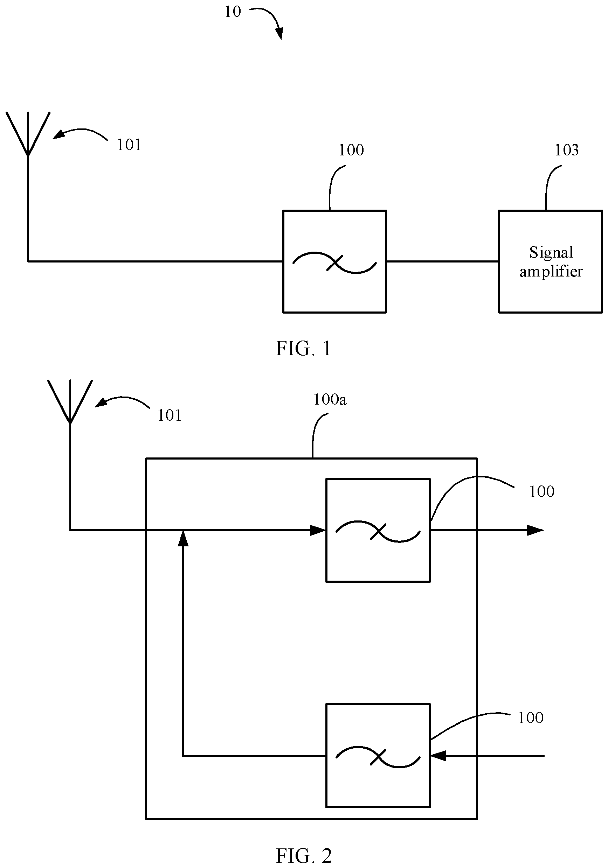

FIG. 1 is a functional module diagram of a radio frequency communication module. As shown in FIG. 1, the radio frequency communication module 10 includes a filter circuit 100, an antenna 101, and a signal amplifier 103. The filter circuit 100 is connected between the antenna 101 and the signal amplifier 103. The connection in this embodiment is an electrical connection that is implemented by using an electrically conductive line and through which an electrical signal can be transmitted.

The antenna 101 is configured to: send a wireless signal to another communication apparatus at different frequencies, or receive a wireless signal from another communication apparatus. In this embodiment, the filter circuit 100 is configured to feed a signal from the signal amplifier 103 to the antenna 101 in a transmit frequency band; or in another embodiment of this application, the filter circuit 100 may be configured to feed a signal from the antenna 20 to the signal amplifier 103 in a receive frequency band. In addition, the filter circuit 100 can suppress various frequencies in the receive frequency band or the transmit frequency band, in other words, filter a radio frequency signal in the receive frequency band.

In this embodiment, the filter circuit 100 is applied to a filter, or in other words, the filter circuit 100 is a filter to filter the radio frequency signal in the receive frequency band or the transmit frequency band.

In this embodiment, FIG. 1 shows only one signal amplifier 103, but the signal amplifier 103 may include a low noise amplifier for performing processing in the receive frequency band and a power amplifier in the transmit frequency band, and a quantity of stages of amplifiers and a quantity of filters between stages may be set based on an actual situation.

It should be noted that, in this embodiment, the filter circuit 100 filters the radio frequency signal on a single channel, that is, the filter circuit 100 separately filters a radio frequency signal in the transmit frequency band or separately filters a video signal in the receive frequency band.

As shown in FIG. 2, in an embodiment of this application, two filter circuits 100 form a duplexer 100a performing filtering on two channels. Certainly, in another embodiment of this application, three or more filter circuits 100 may form a multi-channel multiplexer.

Specifically, as shown in FIG. 2, the two filter circuits 100 in the duplexer 100a separately receive radio frequency signals in different directions and then perform filtering. For example, one of the filter circuits 100 filters a radio frequency signal, that needs to be transmitted to the antenna 101 to be transmitted outside, in the transmit frequency band (TX); then, the other filter circuit 100 filters a radio frequency signal, provided by the antenna 101, in the receive frequency band (RX). In addition, the duplexer 100 further includes a functional circuit (not shown in the figure) configured to separate the transmit frequency band from the receive frequency band. However, in this embodiment, circuit structures of the two filter circuits 100 are basically the same.

By including the filter circuits 100 or the duplexer 100a including the filter circuits 100 to a design of a communication device or a network device, the filter circuits 100 can reduce interference in the radio frequency signal in the transmit frequency band or the radio frequency signal in the receive frequency band.

In this embodiment, the filter circuit 100 may be applied to a surface acoustic wave (Surface Acoustic Wave, SAW) filter. In another embodiment in this application, the filter circuit 100 may alternatively be applied to a bulk acoustic wave (Bulk Acoustic Wave, BAW) filter.

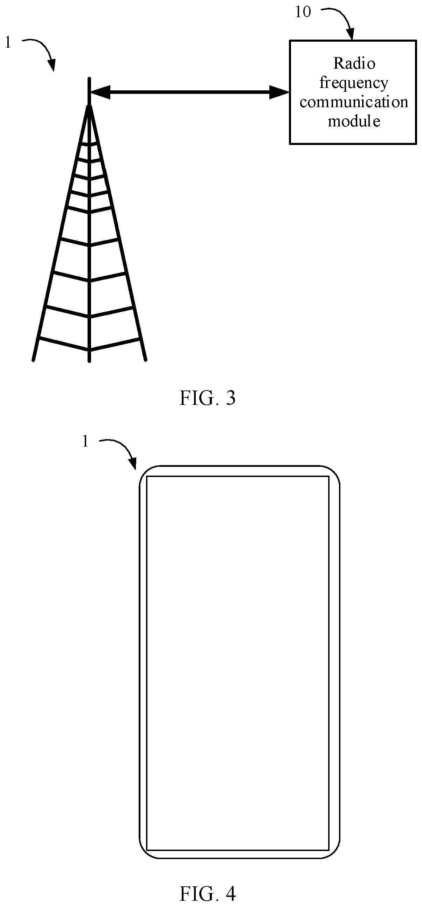

FIG. 3 is a schematic diagram of a structure of a communication apparatus 1 to which the radio frequency communication module 10 shown in FIG. 1 is applied according to an embodiment of this application.

In this embodiment, the communication apparatus 1 is a network device. The network device includes a base station (base station, BS). The base station includes the radio frequency communication module 10 shown in FIG. 1. The base station may be a device that is deployed in a radio access network and that can perform wireless communication with a terminal. The base station may be in a plurality of forms, such as a macro base station, a micro base station, a relay station, and an access point. For example, the base station in embodiments of this application may be a base station in 5G or a base station in LTE. The base station in 5G may also be referred to as a transmission reception point (transmission reception point, TRP) or a gNB. In embodiments of this application, an apparatus configured to implement network device functions may be a network device, or may be an apparatus that can support the network device to implement the functions, for example, a chip system. The apparatus may be installed in the network device.

FIG. 4 is a schematic diagram of a structure of a communication apparatus 1 to which the radio frequency communication module 10 shown in FIG. 1 is applied according to an embodiment of this application.

In this embodiment, the communication apparatus 1 may be a mobile communication device such as a mobile phone or a tablet computer. The mobile communication device may include the radio frequency communication module 10 shown in FIG. 1.

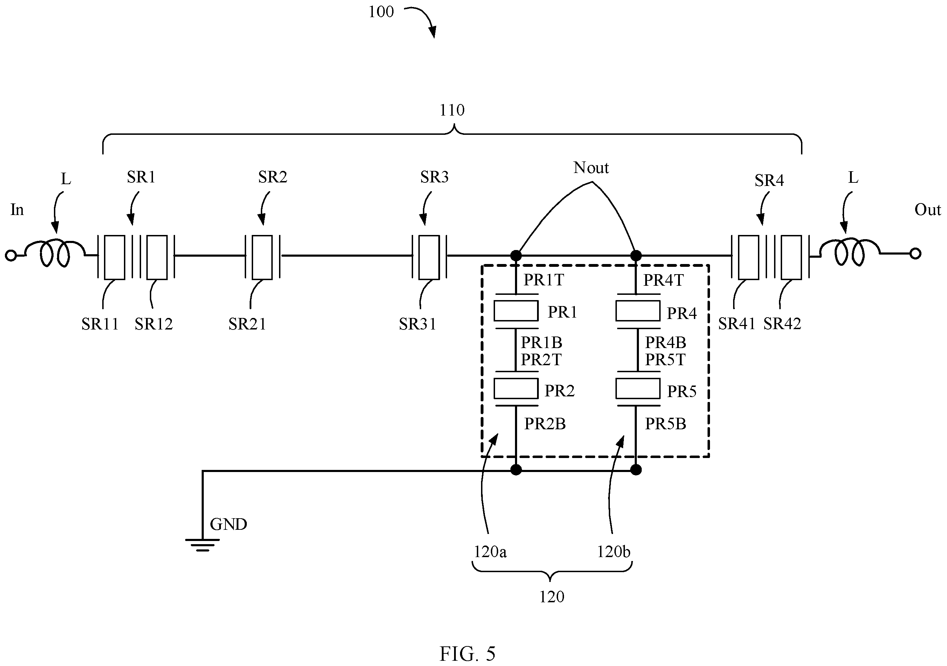

FIG. 5 is a schematic diagram of a circuit structure of the filter circuit 100 shown in FIG. 1 according to an embodiment of this application.

As shown in FIG. 5, the filter circuit 100 includes an input port In, inductors L, a series resonator unit 110, a parallel resonator unit 120, and an output port Out.

In this embodiment, the input port In is connected to the signal amplifier 103 shown in FIG. 1, and is configured to receive a wireless radio frequency signal, provided by the signal amplifier 103, inside the communication apparatus. The output port Out is connected to the antenna 101 to filter a wireless radio frequency signal provided by a functional module inside a terminal in which the radio frequency communication module 10 is located and then transmit the wireless radio frequency signal obtained through filtering using the antenna 101.

Certainly, in another embodiment of this application, the input port In may alternatively be connected to the antenna 101, and is configured to receive a wireless radio frequency signal from the antenna 101; and the output port Out is connected to the signal amplifier 103 to filter a wireless radio frequency signal received by the antenna 101 and provide the wireless radio frequency signal to another functional module inside the terminal.

A series resonator unit 110 is connected in series between the input port In and the output port Out. A parallel resonator unit 120 is electrically connected between any node, between the input port In and the output port Out, and a grounding terminal GND.

In this embodiment, the first series resonator unit 110 includes at least one sub serial resonator unit sequentially connected in series. A quantity of sub serial resonator units may be set based on an actual requirement parameter of the filter circuit 100. For example, the first series resonator unit 110 shown in FIG. 4 includes four sub resonator units sequentially connected in series, and for the input port In, a sub resonator unit located at the last position is connected between a first node Nout and the output port Out. In this embodiment, for ease of description, the four sub serial resonator units are defined as a sub serial resonator unit SRI, a sub serial resonator unit SR2, a sub serial resonator unit SR3, and a sub serial resonator unit SR4. Each sub serial resonator unit SRI, sub serial resonator unit SR2, sub serial resonator unit SR3, and sub serial resonator unit SR4 have low-pass filtering characteristics.

More specifically, the sub serial resonator unit SRI, the sub serial resonator unit SR2, the sub serial resonator unit SR3, and the sub serial resonator unit SR4 are sequentially connected in series with the output port Out from the input port In, and for the input port In, the sub serial resonator unit SR4 located at the last position is connected between the first node Nout and the output port Out. In other words, the node between the sub serial resonator unit SR3 and the sub serial resonator unit SR4 is defined as the first node Nout.

In this embodiment of this application, the first node Nout is any node between the input port In and the output port Out, but no node connected to the parallel resonator unit 120 is disposed between the first node Nout and the output port Out. In other words, because one parallel resonator unit 120 is connected to one node between the input port In and the output port Out, regardless of a quantity of parallel resonator units included in the filter circuit 100, for the input port In, the first node Nout is the node, at the last position, configured to connect to the parallel resonator unit 120. In addition, for the output port Out, the first node Nout is also the node, at a nearest position, configured to connect to the parallel resonator unit 120.

For example, the first node Nout may alternatively be disposed between the sub serial resonator unit SRI and the sub serial resonator unit SR2 or between the sub serial resonator unit SR2 and the sub serial resonator unit SR3 provided that another parallel resonator unit is not disposed between the node, between the first node Nout and the output port Out, and the grounding terminal GND.

Each sub serial resonator unit includes at least one series resonator. In this embodiment, the series resonator unit SRI connected to the input port In includes two series resonators SR11 and SR12 that are connected in series, and the series resonator unit SR4 connected to the output port Out includes two series resonators SR41 and SR42 that are connected in series. Other sub serial resonator units SR2 and SR3 between the sub serial resonator unit SR1 and the sub serial resonator unit SR4 include series resonators SR21 and SR31, in other words, a sub serial resonator unit not directly connected to the input port In or the output port Out includes one series resonator.

In this embodiment, working parameters and structures of the series resonator SR11, the series resonator SR12, the series resonator SR21, the series resonator SR31, and the series resonators SR41 and SR42 may be set to the same or not completely the same based on the actual parameter requirement of the filter circuit 100.

In another embodiment of this application, a quantity of series resonators included in each sub serial resonator unit may be adjusted based on an actual requirement and is not limited thereto.

An inductor L is connected between the input port In and the sub serial resonator unit SR1. Furthermore, an inductor L is also disposed between the sub serial resonator unit SR4 and the output port Out. The inductor L is configured to perform parameter matching with the series resonator unit 110 and the parallel resonator unit 120. Certainly, in another embodiment of this application, alternatively, no inductor L needs to be disposed based on an actual requirement.

In this embodiment, the parallel resonator unit 120 is connected between the input port In and the output port Out, and is a parallel resonator unit at a level closest to the output port Out, in other words, the parallel resonator unit 120 is a parallel resonator unit at the last level to the input port In. Therefore, no parallel resonator unit exists between the parallel resonator unit 120 and the output port Out.

The parallel resonator unit 120 includes at least two parallel resonator tributaries 120a and 120b connected in parallel to each other. The parallel resonator tributaries 120a and 120b each include at least one parallel resonator.

The parallel resonator tributaries 120a and 120b are both connected between the same first node Nout and the grounding terminal GND. In other words, a voltage input to the node connected to the parallel resonator tributary 120a is the same as a voltage input to the node connected to the parallel resonator tributary 120b. That is, no sub serial resonator unit is disposed between the parallel resonator tributaries 120a and 120b.

A quantity M of parallel resonator tributaries may be the same as or different from a quantity N of parallel resonators included in each parallel resonator tributary. M is a natural number greater than or equal to 2, and N is a natural number greater than or equal to 1.

More specifically, when M and N are the same, for example, are both i, the parallel resonators in the parallel resonator unit 120 are arranged in a form of an i^{∗}i matrix, where i is a natural number greater than or equal to 2 and less than or equal to M and N.

For example, when the quantity M of parallel resonator tributaries and the quantity N of parallel resonators in each parallel resonator tributary are both 2, the parallel resonators in the parallel resonator unit 120 are arranged in a form of a 2^{∗}2 matrix.

In this embodiment, when the quantity N of parallel resonators included in each of the parallel resonator tributaries 120a and 120b is greater than or equal to 2, the parallel resonators in each of the parallel tributaries 120a and 120b are sequentially connected in series. The parallel resonator tributaries 120a and 120b may include a same quantity of parallel resonators, for example, 2 or 3; or the parallel resonator tributaries 120a and 120b may include different quantities of parallel resonators. For example, the parallel resonator tributary 120a includes two serial parallel resonators, and the parallel resonator tributary 120a includes three serial parallel resonators.

In this embodiment, when the parallel resonator tributaries 120a and 120b each include two serial parallel resonators, the parallel tributary 120a includes a first parallel resonator PR1 and a second parallel resonator PR2 that are connected in series between the first node Nout and the grounding terminal GND, and the parallel tributary 120b includes a fourth parallel resonator PR4 and a fifth parallel resonator PR6 that are connected in series between the first node Nout and the grounding terminal GND.

More specifically, the first parallel resonator PR1 includes a first electrode PR1T of a first polarity and a second electrode PR1B of a second polarity, and the second parallel resonator PR2 includes a third electrode PR2T of the first polarity and a fourth electrode PR2B of the second polarity. The first electrode PR1T is connected to the first node Nout, the second electrode PR1B is connected to the third electrode PR2T, and the fourth electrode PR2B is connected to the grounding terminal GND. The first polarity is opposite to the second polarity, and electrodes of two different polarities in the parallel resonator operate in opposite phases.

The fourth parallel resonator PR4 includes a seventh electrode PR4T and an eighth electrode PR4B. The fifth parallel resonator PR5 includes a ninth electrode PR5T and a tenth electrode PR5B. The seventh electrode PR4T is connected to the first node Nout, the eighth electrode PR4B is connected to the ninth electrode PR5T, and the tenth electrode PR5B is connected to the grounding terminal GND.

Electrodes of a same polarity, which are arranged at the first position, in parallel resonators in the parallel resonance tributaries 120a and 120b are connected to the first node Nout. For example, as shown in FIG. 4, the first electrode PR1T and the seventh electrode PR4T of the first polarity, which are arranged at the first position, in the parallel resonators in the parallel resonance tributaries 120a and 120b are connected to the first node Nout. Alternatively, in another embodiment of this application, the second electrode PR1B and the eighth electrode PR4B of the second polarity, which are arranged at the first position, in the parallel resonators in the parallel resonance tributaries 120a and 120b are connected to the first node Nout.

Specifically, in this embodiment, the first electrode PR1T and the seventh electrode PR4T of the first polarity, which are arranged at the first position, in the parallel resonance tributaries 120a and 120b are connected to the first node Nout. In addition, the fourth electrode PR2B and the tenth electrode PR5B of the second polarity, which are arranged at the last position, in the parallel resonance tributaries 120a and 120b are connected to the grounding terminal GND. In another embodiment of this application, the first electrode PR1T and the seventh electrode PR4T of the first polarity, which are arranged at the first position, in the parallel resonance tributaries 120a and 120b are connected to the first node Nout. In addition, the fourth electrode PR2B and the tenth electrode PR5B of the second polarity, which are arranged at the last position, in the parallel resonance tributaries 120a and 120b are connected to the grounding terminal GND.

In this embodiment, the first electrode PR1T, the third electrode PR2T, the seventh electrode PR4T, and the ninth electrode PR5T of the first polarity are top electrodes; and the second electrode PR1B, the fourth electrode PR2B, the eighth electrode PR4B, and PR5B of the second polarity are bottom electrodes.

In addition, in this embodiment, series resonators in a plurality of sub serial resonator units and the plurality of parallel resonators in the parallel resonator unit 120 are surface acoustic wave resonators.

With reference to FIG. 5, a filtering working principle of the filter circuit 100 is described in detail.

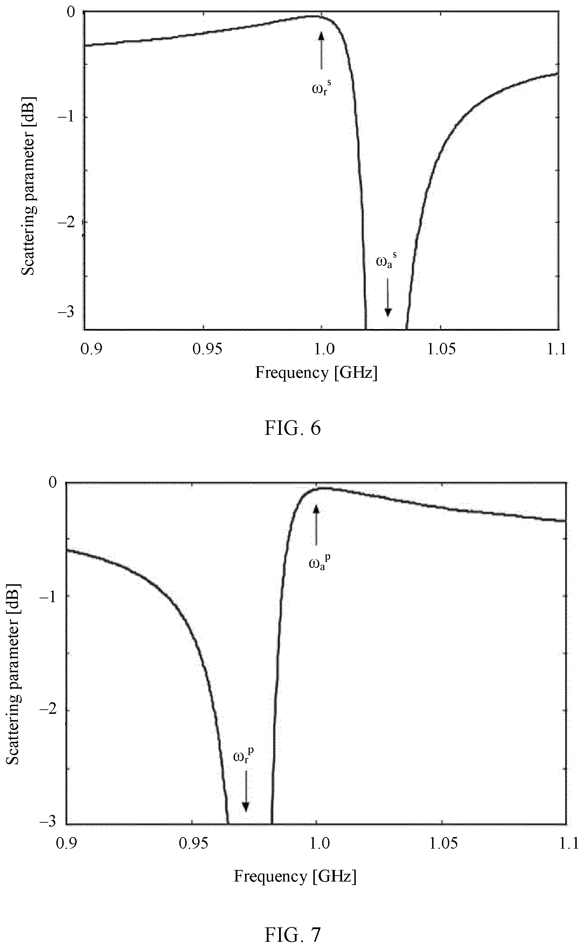

Working principles and characteristics of a plurality of sub serial resonator units are shown in FIG. 6. In FIG. 6, an X-axis is a frequency, a Y-axis is a scattering parameter (representing a transmission loss), a symbol ωas is an anti-resonance frequency of a series resonator, and a symbol ωrs is a resonance frequency of the series resonator. As shown in FIG. 6, a series resonator (Series Resonator) in each series resonator unit has a high impedance characteristic at the anti-resonance frequency ωas and has a low impedance characteristic at the resonance frequency ωrs. In this embodiment, all series resonators have a low-pass filtering characteristic. A low-pass filtering characteristic with a higher suppression capability is presented by connecting a plurality of series resonators in series, in other words, a signal with a frequency less than the frequency ωrs can be transmitted through the series resonator unit 110.

It should be noted that the series resonator is connected in series between the input port In and the output port Out, has a high impedance characteristic at the anti-resonance frequency ωas, and has a low impedance characteristic at the resonance frequency ωrs, so that among radio frequency signals that are input to the series resonator, a radio frequency signal with a low frequency can be transmitted through the series resonator and a radio frequency signal with a high frequency is blocked or suppressed by the series resonator and cannot be transmitted.

In this embodiment, a working characteristic of a series resonator in each sub serial resonator unit is the same, that is, an anti-resonance frequency and a resonance frequency of each series resonator are the same. Therefore, an anti-resonance frequency of each sub serial resonator unit overlaps an anti-resonance frequency of a series resonator included in the sub serial resonator unit, and a resonance frequency of each sub serial resonator unit overlaps a resonance frequency of a series resonator included in the sub serial resonator unit. In addition, an impedance characteristic of each sub serial resonator unit is the same as an impedance characteristic of a series resonator included in the sub serial resonator unit.

A working principle and a characteristic of a parallel resonator (Parallel Resonator) in the parallel resonator unit 120 are shown in FIG. 7. In FIG. 7, an X-axis is a frequency, a Y-axis is a scattering parameter, a symbol coap is an anti-resonance frequency of the parallel resonator, and a symbol corp is a resonance frequency of a parallel resonator. The parallel resonator in the parallel resonator unit has a high impedance characteristic at the resonance frequency corp and has a low impedance characteristic at the anti-resonance frequency ωap. In this embodiment, the plurality of parallel resonators in the parallel resonator unit 120 all have a high-pass characteristic. A high-pass filtering characteristic with a higher suppression capability is presented by using a plurality of parallel resonator tributaries that are connected in parallel and that include a plurality of parallel resonators, in other words, a signal with a frequency greater than the frequency ωap can be transmitted through the parallel resonator unit 120.

It should be noted that the parallel resonator is electrically connected in parallel between the node, between the input port In and the output port Out, and the grounding terminal GND, has a high impedance characteristic at the resonance frequency corp, and has a low impedance characteristic at the anti-resonance frequency ωap, so that among radio frequency signals that are input to the parallel resonator, a radio frequency signal with a high frequency can be output through the parallel resonator and a radio frequency signal with a low frequency is blocked or suppressed by the parallel resonator and cannot be output.

In this embodiment, a working characteristic of a parallel resonator in the parallel resonator unit 120 is the same, that is, an anti-resonance frequency and a resonance frequency of each parallel resonator are the same. Therefore, an anti-resonance frequency of the parallel resonator unit 120 overlaps an anti-resonance frequency of a parallel resonator included in the parallel resonator unit 120, and a resonance frequency of the parallel resonator unit 120 overlaps a resonance frequency of a parallel resonator included in the parallel resonator unit 120. In addition, an impedance characteristic of the parallel resonator unit 120 is the same as an impedance characteristic of a parallel resonator included in the parallel resonator unit 120.

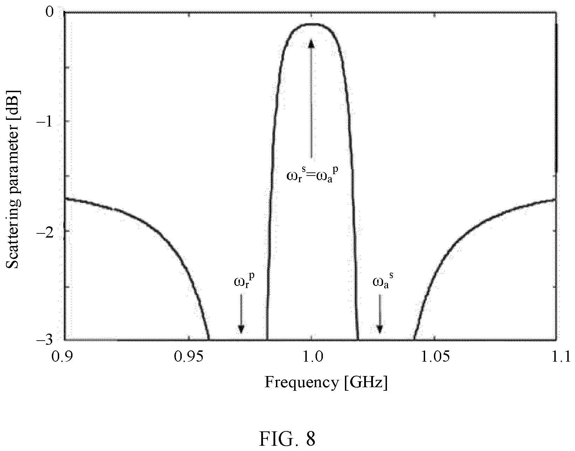

By separately controlling the resonance frequencies and the anti-resonance frequencies of the plurality of sub serial resonator units and the parallel resonator unit 120, a principle of filtering a radio frequency signal by the filter circuit 100 is shown in FIG. 8. When the low-impedance frequency ωrs of a plurality of series resonator units approximately overlaps the low-impedance anti-frequency ωap of the parallel resonator unit 120, the low-impedance frequency ωrs and the low-impedance anti-frequency ωap form a central frequency of a filter circuit passband. When a difference between the resonance frequency of the plurality of sub serial resonator units and the anti-resonance frequency of the parallel resonator unit 120 is within a preset difference range, the central frequency of the bandpass filter circuit is the resonance frequency of the plurality of sub serial resonator units or the anti-resonance frequency of the parallel resonator unit 120. In this embodiment, the preset difference range is 0% to 30% ωrs or 0% to 30% ωap.

In this embodiment, high-impedance frequencies of the plurality of sub serial resonator units and the parallel resonator unit 120 each form a strong suppression point outside a filter circuit passband.

Further, it is found through deep research that a PIM interfering signal in passive inter-modulation PIM interference is strongly related to a power of each resonator, to be specific, a larger power of each resonator usually generates a stronger PIM interfering signal.

In this embodiment, a radio frequency signal flows through the plurality of sub serial resonator units SR1 to SR4 for voltage division and low-pass filtering processing. In addition, the radio frequency signal also flows through the parallel resonator unit 120 for current division and high-pass filtering processing. Furthermore, current division is performed on the radio frequency signal entering the parallel resonator unit 120 by the parallel resonance tributaries 120a and 120b, and voltage division is performed by two parallel resonators connected in series in each parallel resonance tributary. Therefore, a voltage and a current carried by each parallel resonator are effectively reduced, so that a power of each parallel resonator in the parallel resonator unit 120 is reduced to the maximum extent, and an amplitude of the PIM interfering signal is reduced to the maximum extent. Because a power of each parallel resonator is reduced, the passive inter-modulation interference of the filter circuit 100 is effectively suppressed.

In addition, in the filter circuit 100, after the radio frequency signal enters the filter circuit 100 through the input port In, each sub serial resonator unit and each parallel resonator unit that are passed through by the radio frequency signal generate PIM interfering signals, and the PIM interfering signals are gradually accumulated. When the parallel resonator unit 120 performs the last level of filtering on the radio frequency signal, the parallel resonator unit 120 can suppress PIM interfering signals generated by all resonators in a parallel resonator unit between the input port In and the parallel resonator unit 120 to filter out most PIM interfering signals generated by the entire filter circuit 100, and further reduce the PIM interfering signals of the filter circuit 100.

In addition, no other parallel resonator units continue to generate passive inter-modulation interference after the first parallel resonator 120. Therefore, inter-modulation products (PIM interfering signals) of the filter circuit 100 can be effectively reduced only by disposing a parallel resonator unit on a node closest to the output port Out.

Therefore, in this embodiment, because two parallel resonators are connected in series in each of the parallel resonance tributaries 120a and 120b included in the parallel resonator unit 120, PIM3 (3rd Passive Inter Modulation, third passive inter-modulation) in passive inter-modulation can be improved. Because the PIM3 of the filter circuit is a main component of the PIM interference, after the PIM3 interference is suppressed, the interference overally generated by the filter circuit 100 is effectively suppressed, thereby ensuring quality of a wireless radio frequency signal obtained through filtering. Further, because only one parallel resonator unit 120 needs to be disposed on the first node Nout, a volume of the filter circuit 100 is effectively reduced.

In this embodiment, a working principle of the duplexer 100a including two filter circuits 100 is basically the same. Details are not described in this embodiment.

In this embodiment, when the filter circuit 100 is applied to a surface acoustic wave (Surface Acoustic Wave, SAW) filter, the parallel resonator and the series resonator both may be surface acoustic wave resonators. When the filter circuit 100 is applied to a bulk acoustic wave (Bulk Acoustic Wave, BAW) filter, the parallel resonator and the series resonator both may be bulk acoustic wave surface resonators. The surface acoustic wave filter and the bulk acoustic wave filter respectively filter signals transmitted in a form of a surface acoustic wave or a form of a bulk acoustic wave with low interference. The surface acoustic wave is an acoustic wave generated on a surface of an elastic object and transmitted along the surface, and the bulk acoustic wave is an acoustic wave transmitted in a longitudinal direction inside an elastic object.

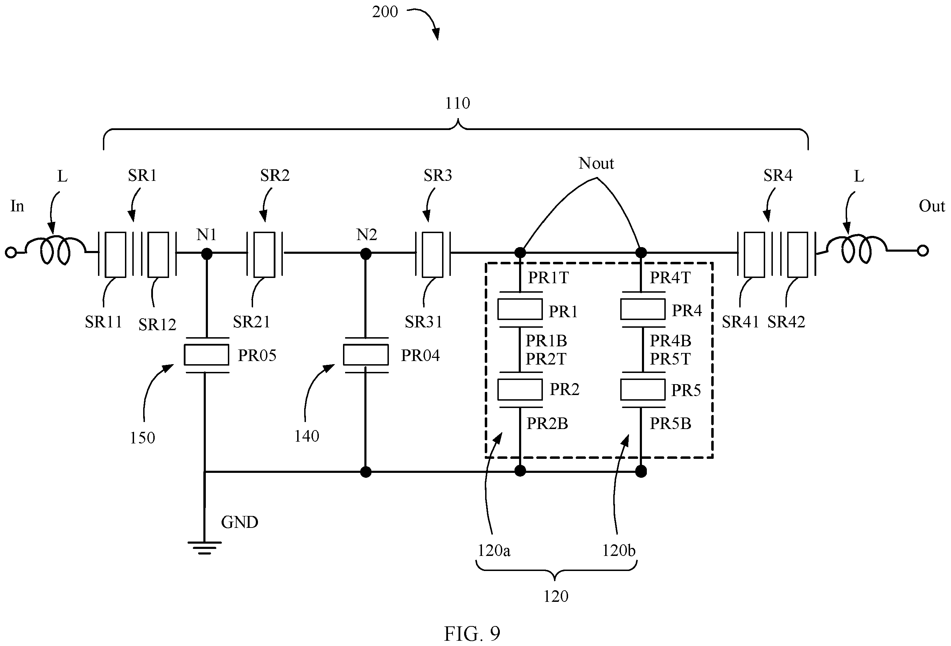

FIG. 9 is a schematic diagram of a circuit structure of the filter circuit 200 shown in FIG. 1 according to another embodiment of this application. In this embodiment, the structure of the filter circuit 200 is basically the same as the structure of the filter circuit 100 shown in FIG. 5. A difference is that the filter circuit 200 further includes a second parallel resonator unit 140 and a third parallel resonator unit 150 in addition to a parallel resonator unit 120. Certainly, a quantity of parallel resonator units included in the filter circuit 200 may be adjusted based on an actual situation. For example, a fourth parallel resonator unit may further be disposed. For ease of description, the parallel resonator unit 120 shown in FIG. 9 may be defined as a first parallel resonator unit 120.

In this embodiment, the second parallel resonator unit 140 and the third parallel resonator unit 150 are connected between a node, between two neighboring sub serial resonator units, and a grounding terminal GND, and the second parallel resonator unit 140 and the third parallel resonator unit 150 each include one parallel resonator.

In this embodiment, in terms of a distance relationship between an input port In and an output port Out and a sequence of the first parallel resonator unit 120, the second parallel resonator unit 140, and the third parallel resonator unit 150, the third parallel resonator unit 150 may be a parallel resonator unit at a level closest to the input port In or may be a first-level parallel resonator unit, the second parallel resonator unit 140 is a second-level parallel resonator unit, and the first parallel resonator unit 120 is a parallel resonator unit at the last level to the input port In, in other words, the first parallel resonator unit 120 is a parallel resonator unit at a level closest to the output port Out.

Compared with the second parallel resonator unit 140 and the third parallel resonator unit 150, the first parallel resonator unit 120 is the parallel resonator unit at the level closest to the output port Out. Therefore, another parallel resonator unit does not exist between the first parallel resonator unit 120 and the output port Out. A parallel resonator unit other than the first parallel resonator unit 120 is disposed between the input port In and the first parallel resonator unit 120.

For example, as shown in FIG. 9, the second parallel resonator unit 140 is connected between a node N1, between a sub serial resonator unit SR1 and a sub serial resonator unit SR2, and the grounding terminal GND; and the third parallel resonator unit 140 is connected between a node N2, between the sub serial resonator unit SR2 and a sub serial resonator unit SR3, and the grounding terminal GND. In this embodiment, a voltage between a first node Nout and the node N1 is different from a voltage between a first node Nout and the node N2. In this case, in the first node Nout, the node N1, and the node N3, for the input port In, the first node Nout is the node, at the last position, configured to connect to the parallel resonator unit. In addition, for the output port Out, the first node Nout is also the node, at a nearest position, configured to connect to the parallel resonator unit.

Specifically, a parallel resonator PR04 included in the second parallel resonator unit 140 is connected between the node N1 and the grounding terminal GND, and a parallel resonator PR05 included in the third parallel resonator unit 150 is connected between the node N2 and the grounding terminal GND. Working parameters and structures of all parallel resonators included in each parallel resonator unit may be set to the same or not completely the same based on an actual parameter requirement of the filter circuit 100.

For example, working parameters, shapes, and structures of the parallel resonator PR04, the parallel resonator PR05, and the first to the fourth parallel resonators PR1 to PR4 may be the same. Certainly, when an actual parameter of the filter circuit 100 needs to be adjusted, the working parameter, the shapes, and the structures of the parallel resonator PR04, the parallel resonator PR05, and the first to the fourth parallel resonators PR1 to PR4 may be not completely the same.

In this embodiment, in addition to the parallel resonator unit 120 disposed between the first node Nout and the grounding terminal GND and the sub serial resonator unit SR4 connected between the first node Nout and the output port Out, the second parallel resonator unit 140 is further disposed between a node, between two random neighboring sub serial resonator units, and the grounding terminal GND, so that inter-modulation products (inter-modulation interfering signals) generated by the filter circuit 100 can further be reduced, and a high-pass filtering effect for a radio frequency signal is effectively improved.

In this embodiment, because two parallel resonators are connected in series in each of the parallel resonance tributaries 120a and 120b included in the parallel resonator unit 120, PIM3 (3rd Passive Inter Modulation, third passive inter-modulation) in passive inter-modulation can be effectively improved. Because the PIM3 of the filter circuit is a main component of the PIM interference, after the PIM3 interference is suppressed, the interference overally generated by the filter circuit 100 is effectively suppressed, thereby ensuring quality of a wireless radio frequency signal obtained through filtering.

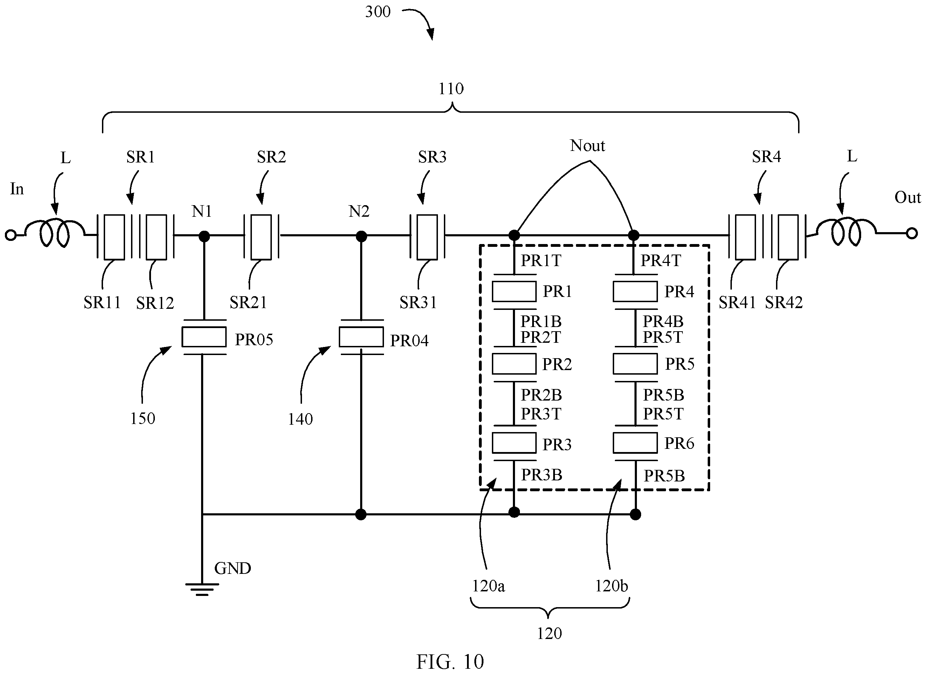

FIG. 10 is a schematic diagram of a circuit structure of the filter circuit 300 shown in FIG. 1 according to another embodiment of this application. In this embodiment, the structure of the filter circuit 300 is basically the same as the structure of the filter circuit 200 shown in FIG. 9. A difference is that in the filter circuit 300, a quantity N of parallel resonators connected in series is 3 in each of the parallel resonator tributaries 120a and 120b, in other words, the parallel resonator tributaries 120a and 120b each include three parallel resonators connected in series.

Specifically, as shown FIG. 10, the parallel tributary 120a includes a first parallel resonator PR1, a second parallel resonator PR2, and a third parallel resonator PR3 that are connected in series between a first node Nout and a grounding terminal GND, and the parallel tributary 120b includes a fourth parallel resonator PR4, a fifth parallel resonator PR5, and a sixth parallel resonator PR6 that are connected in series between the first node Nout and the grounding terminal GND.

More specifically, the first parallel resonator PR1 includes a first electrode PR1T of a first polarity and a second electrode PR1B of a second polarity, the second parallel resonator PR2 includes a third electrode PR2T of the first polarity and a fourth electrode PR2B of the second polarity, and the third parallel resonator PR3 includes a fifth electrode PR3T of the first polarity and a sixth electrode PR3B of the second polarity.

The first electrode PR1T is connected to the first node Nout, the second electrode PR1B is connected to the third electrode PR2T, the fourth electrode PR2B is connected to the fifth electrode PR3T, and the sixth electrode PR3B is connected to the grounding terminal GND.

The fourth parallel resonator PR4 includes a seventh electrode PR4T and an eighth electrode PR4B. The fifth parallel resonator PR5 includes a ninth electrode PR5T and a tenth electrode PR5B. The sixth parallel resonator PR6 includes an eleventh electrode PR6T and a twelfth electrode PR6B.

The seventh electrode PR4T is connected to an output port Out, the eighth electrode PR4B is connected to the ninth electrode PR5T, the tenth electrode PR5B is connected to the eleventh electrode PR6T, and the twelfth electrode PR6B is connected to the grounding terminal GND.

Electrodes of a same polarity, which are arranged at the first position, in parallel resonators in the parallel resonance tributaries 120a and 120b are connected to the output port Out. In this embodiment, the first electrode PR1T and the seventh electrode PR4T of the first polarity, which are arranged at the first position, in the parallel resonance tributaries 120a and 120b are connected to the first node Nout. In addition, the sixth electrode PR3B and the twelfth electrode PR6B of the second polarity, which are arranged at the last position, in the parallel resonance tributaries 120a and 120b are connected to the grounding terminal GND.

In another embodiment of this application, the first electrode PR1T and the seventh electrode PR4T of the first polarity, which are arranged at the first position, in the parallel resonance tributaries 120a and 120b are connected to the grounding terminal GND. In addition, the sixth electrode PR3B and the twelfth electrode PR6B of the second polarity, which are arranged at the last position, in the parallel resonance tributaries 120a and 120b are connected to the first node Nout.

In this embodiment, because each parallel resonator tributary in the parallel resonator unit 120 includes three parallel resonators connected in series, voltage division can further be performed on the radio frequency signal, so that a current and a voltage on each parallel resonator are further reduced, and inter-modulation products (PIM interfering signals) generated by the filter circuit 100 can further be reduced. In this embodiment, because three parallel resonators are connected in series in each of the parallel resonance tributaries 120a and 120b included in the parallel resonator unit 120, PIM3 (3rd Passive Inter Modulation, third passive inter-modulation) in passive inter-modulation can be effectively improved. Because the PIM3 of the filter circuit is a main component of the PIM interference, after the PIM3 interference is suppressed, the interference overally generated by the filter circuit 100 is effectively suppressed, thereby ensuring quality of a wireless radio frequency signal obtained through filtering.

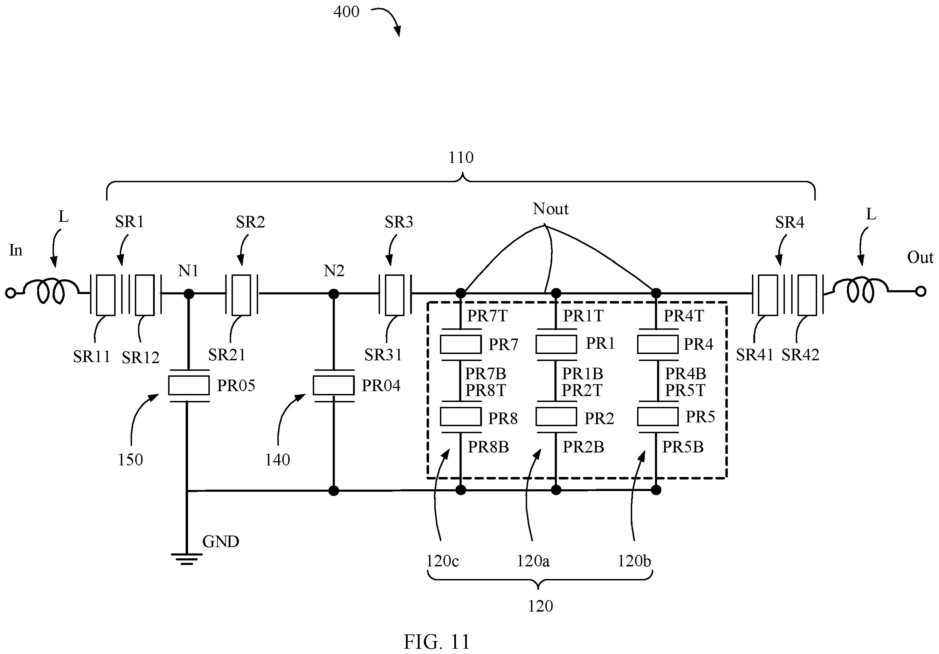

FIG. 11 is a schematic diagram of a circuit structure of the filter circuit 400 shown in FIG. 1 according to another embodiment of this application. In this embodiment, the structure of the filter circuit 400 is basically the same as the structure of the filter circuit 200 shown in FIG. 9. A difference is that in the filter circuit 300, a quantity M of parallel resonator tributaries included in a first parallel resonator unit 120 is 3 and a quantity N of parallel resonators included in each parallel resonator tributary is 2. In other words, the first parallel resonator unit 120 includes three parallel resonator tributaries, and each parallel resonator tributary includes two parallel resonators connected in series.

Specifically, as shown in FIG. 11, the first parallel resonator unit 120 includes at least three parallel resonator tributaries 120a, 120b, and 120c that are connected in parallel to each other. Circuit structures and connection manners of the parallel resonator tributaries 120a and 120b shown in FIG. 11 are the same as the circuit structures and the connection manners of the parallel resonator tributaries 120a and 120b shown in FIG. 4. Details are not described in this embodiment.

The parallel resonator tributary 120c includes a seventh parallel resonator PR7 and an eighth parallel resonator PR8 that are connected in series between an output port Out and a grounding terminal GND.

The seventh parallel resonator PR7 includes a thirteenth electrode PR7T of a first polarity and a fourteenth electrode PR7B of a second polarity. The eighth parallel resonator PR8 includes a fifteenth electrode PR8T of the first polarity and a sixteenth electrode PR2B of the second polarity.

The thirteenth electrode PR7T is connected to a node Nout closest to the output port Out, the fourteenth electrode PR7B is connected to the fifteenth electrode PR8T, and the sixteenth electrode PR2B is connected to the grounding terminal GND.

In this embodiment, two parallel resonators are connected in series in each of the parallel resonance tributaries 120a, 120b, and 120c included in the parallel resonator unit 120. Therefore, because the parallel resonator unit 120 includes three parallel resonator tributaries, current division can further be performed on a radio frequency signal, and a current and a power on each parallel resonator are further reduced, so that PIM3 (3rd Passive Inter Modulation, third inter-modulation) in passive inter-modulation is further improved, and interference overally generated by the filter circuit 100 is effectively suppressed, thereby ensuring quality of a wireless radio frequency signal obtained through filtering. The foregoing describes in detail the filter for improving passive inter-modulation provided in the embodiments of this application. In this specification, specific examples are used to describe the principles and embodiments of this application. The descriptions in the foregoing embodiments are merely used to help understand the method and the core idea of this application. In addition, a person of ordinary skill in the art may make modifications in a specific embodiment and an application scope based on the idea of this application. In conclusion, the content of this specification should not be construed as limiting this application.

## Claims

1. A filter circuit, comprising an input port, a series resonator unit, a parallel resonator unit, and an output port, wherein
the input port is configured to receive a radio frequency signal;
the series resonator unit is connected between the input port and the output port;
the parallel resonator unit comprises M parallel resonator tributaries connected in parallel to each other, the M parallel resonator tributaries are connected between a first node, between the input port and the output port, and a grounding terminal, each of the M parallel resonator tributaries comprises at least one parallel resonator, the parallel resonator unit is a parallel resonator unit at a level closest to the output port, and M is a natural number greater than or equal to 2; and after the series resonator unit cooperates with the parallel resonator unit to filter the radio frequency signal, the radio frequency signal is output from the output port; and
each parallel resonator comprises a first electrode of a first polarity and a second electrode of a second polarity,
wherein
an electrode, connected to the first node, in each parallel resonator tributary is a first electrode of the first polarity;
or
an electrode, connected to the first node, in each parallel resonator tributary is a second electrode of the second polarity.

2. The filter circuit according to claim 1, wherein when each parallel resonator tributary comprises two or more resonators, the two or more parallel resonators are connected in series.

3. The filter circuit according to claim 2, wherein when each parallel resonator tributary comprises N resonators, two parallel resonators comprised in the parallel resonator tributary are connected in series, wherein N is 2, and is a natural number greater than or equal to 2.

4. The filter circuit according to claim 2, wherein when each parallel resonator tributary comprises N resonators, three parallel resonators comprised in the parallel resonator tributary are connected in series, wherein N is 3, and is a natural number greater than or equal to 2.

5. The filter circuit according to claim 1, wherein a quantity of parallel resonators connected in series in each parallel resonator tributary is different.

6. The filter circuit according to any one of claims 1 to 5, wherein the series resonator unit has a high impedance characteristic at an anti-resonance frequency, the parallel resonator unit has a high impedance characteristic at a resonance frequency, the series resonator unit and the parallel resonator unit form a bandpass filter, and a central frequency of the bandpass filter is the resonance frequency of the series resonator unit or the anti-resonance frequency of the parallel resonator unit.

7. The filter circuit according to claim 6, wherein the filter circuit is a surface acoustic wave filter.

8. The filter circuit according to claim 6, wherein the filter circuit is a bulk acoustic wave filter.

9. A duplexer, comprising two filter circuits according to any one of claims 1 to 8, wherein the two filter circuits respectively filter radio frequency signals in a radio frequency signal receiving direction and a radio frequency signal sending direction.

10. A communication apparatus, comprising the filter circuit according to any one of claims 1 to 8.

11. The communication apparatus according to claim 10, further comprising an antenna, wherein the antenna is connected to the filter circuit.
